# EUROPEAN PATENT SPECIFICATION

(11) **EP 1 426 779 B1**
(45) Date of publication and mention of the grant of the patent: **15.08.2007**
(21) Application number: 02017334.0
(22) Date of filing: 02.08.2002
(51) Int. Cl.: G01R 31/319, H04L 7/033

(54) **BER tester with signal sampling with clock recovery**
BER tester mit Signalabtastung mit Taktrückgewinnung
BER tester avec échantillonnage de signal avec récupération d'horloge

(30) Priority: 25.07.2002 EP 02016599
(43) Date of publication of application: 09.06.2004
(73) Proprietor: Agilent Technologies, Inc., Santa Clara, CA 95051 (US)
(72) Inventor: Moll, Joachim, 71083 Herrenberg (DE)
(74) Representative: Barth, Daniel Mathias

(56) References cited:
- EP-A- 0 758 171
- EP-A- 1 191 735
- EP-A- 1 241 483
- WO-A-01/20452
- WO-A-01/71966
- US-A- 2002 063 553
- US-B1- 6 411 665
- MCCORMACK, GARY: "Intelligent Data Recovery" COMMUNICATION SYSTEMS DESIGN, [Online] vol. 5, no. 12, December 1999 (1999-12), XP002276877 Retrieved from the Internet: <URL:http://www.commsdesign.com/main/1999/ 12/9912feat2.htm> [retrieved on 2004-04-14]
- "Agilent 81250 Parallel Bit Error Ratio Tester - System Setup Examples" AGILENT TECHNOLOGIES, March 2002 (2002-03), pages 1-102,

## Description

### BACKGROUND OF THE INVENTION

The present invention relates to the characterization of transient behavior of digital signals.

Characterizing the transient behavior of digital signals, i.e. the transition from logical zero to logical one, and vice versa, has become increasing important for designing as well as manufacturing such digital circuits, and is disclosed e.g. in the European Patent application No. 01106632.1 (EP 1241483 A1). For testing a device under test (DUT), usually one or multiple stimulus signals are applied to the DUT and one or multiple response signals onto the stimulus signals are detected and analyzed (e.g. by comparing the detected response signal with an expected response signal).

A standard characterization of digital circuits requires determining the so-called Bit Error Rate (BER), i.e. the ratio of erroneous digital signals (Bits) to the total number of regarded digital signals. Bit Error Rate Testers (BERTs), such as the Agilent^{®} 81250 ParBERT Platform with and Agilent^{®} E4875A User Software and Measurement Software both by the applicant Agilent Technologies, are provided to determine a so-called BER eye diagram as a two-dimensional graphical representation generated using a sweep over delay and threshold of an analyzer. The result is an eye pattern with a BER value dependent on the sampling point for a plurality of sampling points.

Each sampling point is determined by a relative (e.g. delay) time with respect to corresponding transition of a clock signal (usually the system clock for generating the stimulus signals or a clock signal derived therefrom) and a threshold value for comparing the response signal with. The maximum number of sampling points is usually dependent on the resolution of the analyzer. In order to decrease measurement time, the number of sampling points is usually kept as low as possible. The BER eye diagram gives information which BER value can be expected depending on the position of the sampling point within the eye. Parameters like jitter, level noise, phase margin, and quality factor (Q-factor) can be calculated from the BER eye diagram.

WO 01/20452 discloses a protocol and bit rate independent test system for detecting bit errors on a digital communications channel. The system includes a threshold sampling circuit including a plurality of threshold detectors.

The article "Intelligent Data Recovery" COMMUNICATION SYSTEM DESIGN, (online) vol. 5, no. 12, December 1999 of Gary McCormack discloses a data and clock recovery unit with a self-adjusting feedback loop.

WO 01/71966 discloses a data recovery unit with an adjustable sampling and comparison level including a data channel and a monitor channel. The results of the sampling in the monitor channel are used to adjust the sampling and comparing of the signal in the data channel.

US 2002/0063553 A1 discloses a bit error rate tester with the features of the preamble to claim 1.

### SUMMARY OF THE INVENTION

It is an object of the present invention to provide an improved transient testing. The object is solved by the independent claims. Preferred embodiments are shown by the dependent claims.

According to the present invention, a signal-sampling unit for sampling a digital test signal comprises a sampling path and a clock recovery unit, both receiving the test signal.

The sampling path comprises a first comparator for comparing the test signal against a first threshold value (e.g. a threshold voltage) and providing a first comparison signal as result of the comparison. A sampling device receives as input the first comparison signal together with a timing signal comprising a

plurality of successive timing marks. The sampling device is adapted to derive a value of the first comparison signal for one or more (and preferably each) of the timing marks. The sampling device provides as an output a sampling signal representing the derived value(s) of the first comparison signal over or in relation to the respective timing mark(s).

The sampling signal is subjected (directly or after further processing) to further analysis by an analysis unit for comparing the sampling signal with an expected response signal in order to determine a value of BER. The test signal is received from a device under test (DUT) as a response signal (e.g. onto a stimulus signal applied to the DUT), the sampling signal represents a detected response signal. The analysis unit then compares the detected response signal with an expected response signal.

The clock recovery unit receives the test signal and derives therefrom a clock signal. The clock signal is further provided to a timing unit for generating the timing signal comprising the timing marks (as applied to the sampling device for sampling the first comparison signal derived from the test signal).

In a preferred embodiment, the clock recovery unit comprises a second comparator for comparing the test signal against a second threshold value and for providing a second comparison signal as result of the comparison.

In one embodiment, the clock recovery unit further comprises a clock generator and a phase control unit. The clock generator generates the clock signal having substantially the same frequency as a signal clock associated with the test signal. In a further embodiment, wherein the clock generator is tunable in frequency, the clock recovery unit further comprises a frequency correction unit for substantially adjusting the frequency of the clock generator to the frequency of the signal clock.

The phase control unit receives the second comparison signal (from the second comparator) as well as the clock signal (generated by the clock generator) and determines a difference in the phases there-between. The phase control unit controls the clock generator in order to minimize deviations in phase between the generated clock signal and the second comparison signal.

In another embodiment, the clock signal is derived by converting the second comparison signal into a return-to-zero (RZ) signal and feeding this signal to a filter (preferably band-pass or notch filter) to extract the clock signal.

Other schemes as known in the art for deriving the clock signal from the test signal can be applied accordingly.

The generated clock signal is further provided to the timing unit for generating the timing marks. The timing unit preferably derives the timing marks from transitions in the clock signal (preferably from either one of a rising or falling edges). The timing unit might preferably further allow modifying the timing marks with respect to corresponding transitions in the clock signal. Preferably, the timing marks can be delayed with respect to corresponding transitions. This can be achieved e.g. by a phase shift or delay unit receiving the clock signal and being adapted to (preferably variably) shift the phase of the clock signal and provide the phase shifted clock signal to the sampling device. This allows delaying the timing marks with respect to the transitions of the clock signal.

In operation for sampling the test signal, the test signal is applied to the first comparator of the sampling path as well as to the clock recovery unit. While the first comparator provides the first comparison signal from comparing the test signal against the first threshold value, the clock recovery unit derives the clock signal from the test signal. The clock signal is then used to derive the timing marks provided in the timing signal to the sampling device for sampling the first comparison signal at one or more of the timing marks. The sampling signal (comprising the sampled value for each timing mark) is then provided as an output of the sampling device and might be subject to further analysis provided e.g. by the analysis unit. The analysis unit compares the sampling signal (directly or after further processing) with an expected signal (the expected response signal of the DUT).

In one embodiment, each of the first and the second comparators compares the test signal against a respective threshold value (the first or the second threshold value) and provides as comparison signal a first value in case the test signal is greater than the threshold value and a second value in case the test signal is smaller than the threshold value.

In one embodiment, only one comparator is provided instead of the first and the second comparators. The one comparator receives as input the test signal and compares the test signal against one threshold value and provides a comparison signal therefrom. The comparison signal is then provided as input to the sampling device as well as to the phase control unit. Providing two independent comparators and threshold values, however, allows to independently varying the respective threshold values. This might be of advantage in order to safely derive the clock signal (and thus the timing signal) from the test signal, while still allowing the sampling device to sample at each possible threshold value (as determined by the first threshold value together with the first comparator).

In one embodiment, the second threshold value is selected to ensure a save detection of the test signal (i.e. to minimize measuring uncertainty). Preferably, the second threshold value is selected to be substantially in the middle of an eye diagram for the test signal. Preferably, the second threshold value is selected to be substantially half of the voltage difference between an upper and a lower signal level of the test signal.

It is clear that the digital test signal may also be a differential signal. In that case preferably a level-shifting unit as disclosed in the European Patent application No. 02015432.4. (not published) is applied.

It is clear that the invention can be partly or entirely embodied or supported by one or more suitable software programs, which can be stored on or otherwise provided by any kind of data carrier, and which might be executed in or by any suitable data processing unit.

### BRIEF DESCRIPTION OF THE DRAWINGS

Other objects and many of the attendant advantages of the present invention will be readily appreciated and become better understood by reference to the following detailed description when considering in connection with the accompanied drawings. Features that are substantially or functionally equal or similar will be referred to with the same reference sign(s).

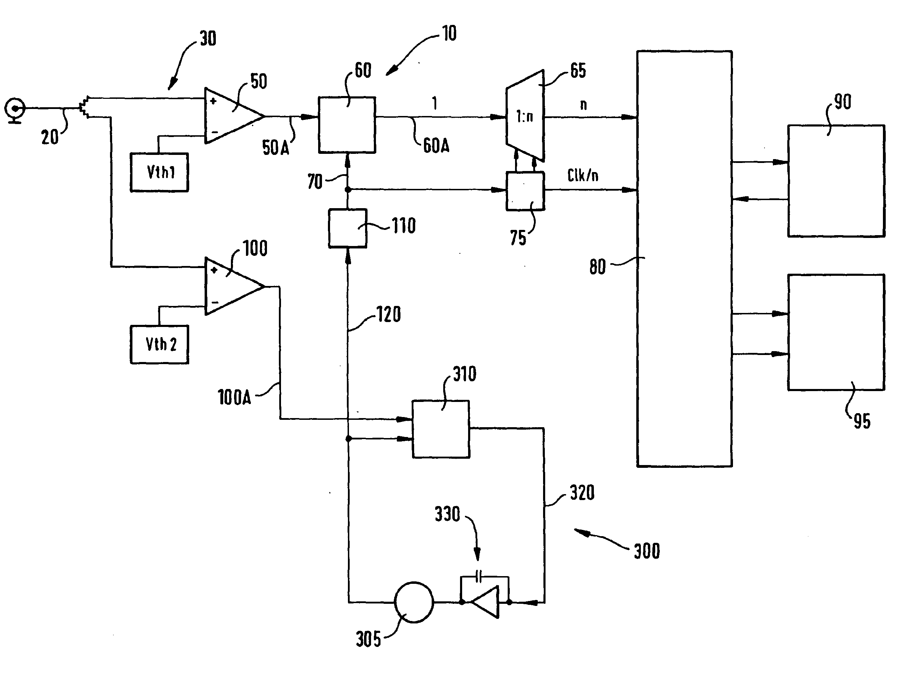

Fig. 1 shows an example of an embodiment according to the present invention.

### DETAILED DESCRIPTION OF THE INVENTION

In Fig. 1, a signal-sampling unit 10 for sampling a (digital) test signal 20 comprises a sampling path 30 and a clock recovery unit 300, both receiving the test signal 20.

The sampling path 30 comprises a first comparator 50 for comparing the test signal 20 against a first threshold value (Vth1) and providing a first comparison signal 50A as result of the comparison. The first comparator 50 provides as the comparison signal 50A a first value (preferably a HIGH signal) in case the test signal is greater than the threshold value and a second value (preferably a LOW signal) in case the test signal is smaller than the threshold value.

A sampling device 60 receives as input the first comparison signal 50A together with a timing signal 70 comprising a plurality of successive timing marks. The sampling device 60 is adapted to derive a value of the first comparison signal for one or more (and each) of the timing marks. The sampling device 60 provides as an output a sampling signal 60A representing the derived value(s) of the first comparison signal 50A over the respective timing mark(s).

The sampling signal 60A is subject (directly or after further processing) to further analysis by an analysis unit 80 (for comparing the sampling signal 60A with an expected response signal, which might be stored in a memory 90). Further, the analysis unit 80 might store the sampling signal 60A (e.g. for later analysis) in a memory 95).

Optionally, a demultiplexer 65 and a divider 75 might be coupled before the inputs of the analysis unit 80 in order to decrease the data rate of the received signal. Often the BER-logic is implemented in lower speed digital circuits, e.g. FPGA's, and thus the high-speed data stream is broken up into several lower speed signals. This procedure is called demultiplexing or deserializing and is done with the demultiplexer 65. A divider 75 controls the demultiplexer 65and delivers a lower speed clock to the analysis unit 80.

The clock recovery unit 300 receives the test signal 20 and derives therefrom the timing signal 70. The clock recovery unit 300 comprises a second comparator 100 for comparing the test signal 20 against a second threshold value Vth2 and for providing a second comparison signal 100A as result of the comparison. The second comparator 100 provides as the comparison signal 100A a first value (preferably also the HIGH signal) in case the test signal is greater than the threshold value and a second value (preferably also the LOW signal) in case the test signal is smaller than the threshold value.

The clock recovery unit 300 further comprises a clock generator 305, a phase control unit 310, and a timing unit 110 for providing the timing marks in the timing signal. The clock generator 305 generates a clock signal 120 having substantially the same frequency as a signal clock associated with the test signal 20. The phase control unit 310 receives the second comparison signal 100A as well as the clock signal 120 and determines a difference in the phases there-between. An output 320 of the phase control unit controls the clock generator 305 in order to minimize deviations in phase between the generated clock signal 120 and the second comparison signal 100A. A loop filter 330, e.g. as the example shown in Fig. 1, can be inserted to stabilize the response of the loop and prevent the loop from oscillating.

The generated clock signal 120 is further provided to the timing unit 110 for generating the timing signal 70. The timing unit 110 preferably derives the timing marks from transitions in the clock signal 120 (preferably from either one of a rising or falling edges). The timing unit 110 further allows modifying the timing marks with respect to corresponding transitions in the clock signal 120 by controllably delaying the timing marks with respect to corresponding transitions.

In operation for sampling the test signal 20, the first comparator 50 provides the first comparison signal 50A by comparing the test signal 20 against the first threshold value Vth1, and the clock recovery unit 300 derives the clock signal 120 from the test signal 20. The clock signal 120 is then used to derive the timing marks provided in the timing signal 70 to the sampling device 60 for sampling the first comparison signal 50A at the timing marks. The sampling signal 60A is then provided to the analysis unit 80, which compares the sampling signal with an expected signal.

While only one comparator could be provided instead of the first and the second comparators 50 and 100 (its comparison signal is then provided as input to the sampling device 60 as well as to the phase control unit 310), providing two independent comparators 50 and 100 allows to independently varying the respective threshold values Vth1 and Vth2.

Preferably, the second threshold value Vth2 together with the timing marks are selected to ensure a safe detection of the test signal 20, e.g. by selecting the sampling point (defined by second threshold value Vth2 together with the timing marks) to be substantially in the middle of an eye diagram for the test signal 20. This allows to safely deriving the clock signal 120 from the test signal 20.

The first threshold value Vth1, however, is preferably provided to be variable in order to allow the sampling device 60 to sample at each possible threshold value. Varying the relative (e.g. delay) time of the timing marks with respect to corresponding transitions of the clock signal 120 then allows to further analyze the test signal 20 along its time axes. Thus e.g. an eye diagram of the test signal 20 can be determined.

## Claims

1. A bit error rate tester for determining a bit error rate of a digital test signal (20) received from a device under test -DUT- comprising:
a signal-sampling unit (10) adapted for sampling the digital test signal (20), comprising:
a sampling path (30) adapted for receiving the digital test signal (20) comprising:
a first comparator (50) adapted for comparing the digital test signal (20) against a first threshold value (Vth1) and providing a first comparison signal (50A) as result of the comparison, and
a sampling device (60) adapted for receiving as input the first comparison signal (50A) together with a timing signal (70) comprising a plurality of successive timing marks, wherein the sampling device (60) is adapted to derive a value of the first comparison signal (50A) for one or more of the timing marks, and providing a sampling signal (60A) representing the derived value of the first comparison signal for each corresponding timing mark,
an analysis unit (80) adapted to determine a bit error rate of the digital test signal (20), by comparing the sampling signal (60A) with an expected response signal of the DUT,
**characterized by**
a clock recovery unit (300) adapted for deriving the timing signal (70) from the digital test signal (20).

2. The signal-sampling unit (10) of claim 1, wherein the clock recovery unit (300) is adapted to derive from the digital test signal (20) a clock signal in order to derive therefrom the timing signal (70).

3. The signal-sampling unit (10) of claim 1 or any one of the above claims, wherein the clock recovery unit (300) comprises a second comparator (100) for comparing the digital test signal (20) against a second threshold value (Vth2) and for providing a second comparison signal (100A) as result of the comparison.

4. The signal-sampling unit (10) of claim 1 or any one of the above claims, wherein the clock recovery unit (300) comprises a clock generator (305) and a phase control unit (310), wherein the clock generator (305) generates the clock signal having substantially the same frequency as a signal clock associated with the test signal, and the phase control unit (310) determines a difference in the phases between the received comparison signal and the clock signal for controlling the clock generator.

5. The signal-sampling unit (10) of claim 3, wherein the clock recovery unit (300) comprises a converter adapted for converting the received comparison signal into a return-to-zero signal, and a filter adapted for receiving the return-to-zero signal and extracting the clock signal therefrom.

6. The signal-sampling unit (10) of claim 1 or any one of the above claims, wherein the clock recovery unit (300) comprises a timing unit (110) receiving the clock signal and being adapted for generating the timing marks by providing at least one of the following: deriving the timing marks from transitions in the clock signal, deriving the timing marks from rising or falling edges in the clock signal, delaying the timing marks with respect to corresponding transitions in the clock signal, and shifting the phase of the clock signal.

7. The signal-sampling unit (10) of claim 1 or any one of the above claims, wherein each comparator (50, 100) compares the test signal against a respective threshold value (Vth1, Vth2) and provides as the comparison signal a first value in case the test signal is greater than the threshold value and a second value in case the test signal is smaller than the threshold value.

8. A method of determining a bit error rate of a digital test signal (20) received from a device under test -DUT-, comprising:
(a) comparing the digital test signal (20) against a first threshold value (Vth1) and providing a first comparison signal (50A) as result of the comparison,
(b) deriving a value of the first comparison signal (50A) for one or more timing marks of a timing signal (70) and providing a sampling signal (60A) representing the derived value of the first comparison signal for each corresponding timing mark, and
(c) determining a bit error rate of the digital test signal (20), by comparing the sampling signal (60A) with an expected response signal of the DUT,
**characterized by**
(d) deriving the timing signal (70) with the successive timing marks from the digital test signal (20).

9. The method of claim 8, wherein the step(d) comprises a step of deriving from the digital test signal (20) a clock signal in order to derive therefrom the timing signal (70).

## Patentansprüche

1. Bitfehlerratentester zur Ermittlung einer Bitfehlerrate eines digitalen Testsignals (20), das von einer zu testenden Einheit (Device Under Test - DUT) empfangen wird, wobei der Bitfehlerratentester Folgendes umfasst:
eine Signalabtasteinheit (10) zum Abtasten des digitalen Testsignals (20), wobei die Signalabtasteinheit Folgendes umfasst:
einen Abtastpfad (30) zum Empfangen des digitalen Testsignals (20), wobei der Abtastpfad Folgendes umfasst:
einen ersten Komparator (50) zum Vergleichen des digitalen Testsignals (20) mit einem ersten Schwellenwert (Vth1) und zum Bereitstellen eines ersten Vergleichssignals (50A) als Ergebnis des Vergleichs, und
eine Abtasteinrichtung (60) zum Empfangen des ersten Vergleichssignals (50A) als Eingangswert zusammen mit einem Zeitsignal (70), das eine Vielzahl aufeinanderfolgender Zeitmarken umfasst, wobei die Abtasteinrichtung (60) dafür eingerichtet ist, für eine oder mehrere der Zeitmarken einen Wert des ersten Vergleichssignals (50A) abzuleiten, und zum Bereitstellen eines Abtastsignals (60A), das den abgeleiteten Wert des ersten Vergleichssignals für jede entsprechende Zeitmarke darstellt,
eine Analyseeinheit (80) zum Ermitteln einer Bitfehlerrate des digitalen Testsignals (20) durch Vergleichen des Abtastsignals (60A) mit einem erwarteten Antwortsignal der DUT,
**gekennzeichnet durch**
eine Taktrückgewinnungseinheit (300) zum Ableiten des Zeitsignals (70) vom digitalen Testsignal (20).

2. Signalabtasteinheit (10) nach Anspruch 1, bei der die Taktrückgewinnungseinheit (300) dafür eingerichtet ist, ein Taktsignal vom digitalen Testsignal (20) abzuleiten, um von diesem ein Zeitsignal (70) abzuleiten.

3. Signalabtasteinheit (10) nach Anspruch 1 oder einem der obigen Ansprüche, bei der die Taktrückgewinnungseinheit (300) einen zweiten Komparator (100) zum Vergleichen des digitalen Testsignals (20) mit einem zweiten Schwellenwert (Vth2) und zum Bereitstellen eines zweiten Vergleichssignals (100A) als Ergebnis des Vergleichs umfasst.

4. Signalabtasteinheit (10) nach Anspruch 1 oder einem der obigen Ansprüche, bei der die Taktrückgewinnungseinheit (300) einen Taktgenerator (305) und eine Phasensteuereinheit (310) umfasst, wobei der Taktgenerator (305) das Taktsignal mit im Wesentlichen derselben Frequenz wie der zum Testsignal gehörende Signaltakt erzeugt und wobei die Phasensteuereinheit (310) eine Phasendifferenz zwischen dem empfangenen Vergleichssignal und dem Taktsignal ermittelt, um den Taktgenerator zu steuern.

5. Signalabtasteinheit (10) nach Anspruch 3, bei der die Taktrückgewinnungseinheit (300) einen Umsetzer zum Umsetzen des empfangenen Vergleichssignals in ein Retum-to-Zero-Signal und ein Filter zum Empfangen des Retum-to-Zero-Signals und zum Entnehmen des Taktsignals aus diesem Signal umfasst.

6. Signalabtasteinheit (10) nach Anspruch 1 oder einem der obigen Ansprüche, bei der die Taktrückgewinnungseinheit (300) eine Zeitgebereinheit (110) umfasst, die das Taktsignal empfängt und zum Erzeugen der Zeitmarken eingerichtet ist, indem sie mindestens eine der folgenden Funktionen bereitstellt: Ableiten der Zeitmarken von Übergängen im Taktsignal, Ableiten der Zeitmarken von ansteigenden oder fallenden Flanken des Taktsignals, Verzögern der Zeitmarken in Bezug auf entsprechende Übergänge im Taktsignal und Verschieben der Phase des Taktsignals.

7. Signalabtasteinheit (10) nach Anspruch 1 oder einem der obigen Ansprüche, bei der jeder Komparator (50, 100) das Testsignal mit einem entsprechenden Schwellenwert (Vth1, Vth2) vergleicht und als Vergleichssignal einen ersten Wert liefert, wenn das Testsignal größer als der Schwellenwert ist, und einen zweiten Wert liefert, wenn das Testsignal kleiner als der Schwellenwert ist.

8. Verfahren zum Ermitteln einer Bitfehlerrate eines digitalen Testsignals (20), das von einer zu testenden Einheit (DUT) empfangen wird, wobei das Verfahren die folgenden Schritte umfasst:
(a) Vergleichen des digitalen Testsignals (20) mit einem ersten Schwellenwert (Vth1) und Bereitstellen eines ersten Vergleichssignals (50A) als Ergebnis des Vergleichs;
(b) Ableiten eines Wertes des ersten Vergleichssignals (50A) für eine oder mehrere Zeitmarken eines Zeitsignals (70) und Bereitstellen eines Abtastsignals (60A), das den abgeleiteten Wert des ersten Vergleichssignals für jede entsprechende Zeitmarke darstellt, und
(c) Ermitteln einer Bitfehlerrate des digitalen Testsignals (20) durch Vergleichen des Abtastsignals (60A) mit einem erwarteten Antwortsignal der DUT
**gekennzeichnet durch**
(d) Ableiten des Zeitsignals (70) mit den aufeinanderfolgenden Zeitmarken von dem digitalen Testsignal (20).

9. Verfahren nach Anspruch 8, bei dem der Schritt (d) einen Schritt des Ableitens eines Taktsignals von dem digitalen Testsignal (20) umfasst, um von diesem das Zeitsignal (70) abzuleiten.

## Revendications

1. Dispositif de mesure du taux d'erreurs sur les bits pour déterminer un taux d'erreurs sur les bits d'un signal d'essai numérique (20) reçu d'un dispositif à l'essai - DUT (Device Under Test) - comprenant :
une unité d'échantillonnage de signal (10) à même d'échantillonner le signal d'essai numérique (20), comprenant :
un chemin d'échantillonnage (30) à même de recevoir le signal d'essai numérique (20) comprenant :
un premier comparateur (50) à même de comparer le signal d'essai numérique (20) à une première valeur de seuil (Vth1) et de fournir un premier signal de comparaison (50A) à la suite de la comparaison, et
un dispositif d'échantillonnage (60) à même de recevoir comme entrée le premier signal de comparaison (50A) ainsi qu'un signal de cadencement (70) comprenant une pluralité de marques de cadencement successives, dans lequel le dispositif d'échantillonnage (60) est à même de dériver une valeur du premier signal de comparaison (50A) pour une ou plusieurs des marques de cadencement, et de fournir un signal d'échantillonnage (60A) représentant la valeur dérivée du premier signal de comparaison pour chaque marque de cadencement correspondante ;
une unité d'analyse (80) à même de déterminer un taux d'erreurs sur les bits du signal d'essai numérique (20), en comparant le signal d'échantillonnage (60A) à un signal de réponse attendu du DUT ;
**caractérisé par**
une unité d'extraction du signal d'horloge (300) à même de dériver le signal de cadencement (70) du signal d'essai numérique (20).

2. Unité d'échantillonnage de signal (10) suivant la revendication 1, dans laquelle l'unité d'extraction du signal d'horloge (300) est à même de dériver du signal d'essai numérique (20) un signal d'horloge afin d'en dériver le signal de cadencement (70).

3. Unité d'échantillonnage de signal (10) suivant la revendication 1 ou l'une quelconque des revendications précédentes, dans laquelle l'unité d'extraction du signal d'horloge (300) comprend un deuxième comparateur (100) pour comparer le signal d'essai numérique (20) à une deuxième valeur de seuil (Vth2) et de fournir un deuxième signal de comparaison (100A) à la suite de la comparaison.

4. Unité d'échantillonnage de signal (10) suivant la revendication 1 ou l'une quelconque des revendications précédentes, dans laquelle l'unité d'extraction du signal d'horloge (300) comprend un générateur de signal d'horloge (305) et une unité de commande de phase (310), dans laquelle le générateur de signal d'horloge (305) génère le signal d'horloge avec pratiquement la même fréquence qu'un signal d'horloge associé au signal d'essai, et l'unité de commande de phase (310) détermine une différence entre les phases du signal de comparaison reçu et du signal d'horloge pour commander le générateur de signal d'horloge.

5. Unité d'échantillonnage de signal (10) suivant la revendication 3, dans laquelle l'unité d'extraction du signal d'horloge (300) comprend un convertisseur à même de convertir le signal de comparaison reçu en un signal de retour à zéro, et un filtre à même de recevoir le signal de retour à zéro et d'en extraire le signal d'horloge.

6. Unité d'échantillonnage de signal (10) suivant la revendication 1 ou l'une quelconque des revendications précédentes, dans laquelle l'unité d'extraction du signal d'horloge (300) comprend une unité de cadencement (110) recevant le signal d'horloge et étant à même de générer les marques de cadencement en permettant au moins une des opérations suivantes : la dérivation des marques de cadencement de transitions dans le signal d'horloge, la dérivation des marques de cadencement de flancs avant ou arrière dans le signal d'horloge, le retard des marques de cadencement par rapport aux transitions correspondantes dans le signal d'horloge et le décalage de la phase du signal d'horloge.

7. Unité d'échantillonnage de signal (10) suivant la revendication 1 ou l'une quelconque des revendications précédentes, dans laquelle chaque comparateur (50, 100) compare le signal d'essai à une valeur de seuil (Vth1, Vth2) respective et fournit comme signal de comparaison une première valeur dans le cas où le signal d'essai est supérieur à la valeur de seuil et une deuxième valeur dans le cas où le signal d'essai est inférieur à la valeur de seuil.

8. Procédé permettant de déterminer un taux d'erreurs sur les bits d'un signal d'essai numérique (20) reçu d'un dispositif à l'essai - DUT -, comprenant :
(a) la comparaison du signal d'essai numérique (20) à une première valeur de seuil (Vth1) et la fourniture d'un premier signal de comparaison (50A) à la suite de la comparaison ;
(b) la dérivation d'une valeur du premier signal de comparaison (50A) pour une ou plusieurs des marques de cadencement d'un signal de cadencement (70) et la fourniture d'un signal d'échantillonnage (60A) représentant la valeur dérivée du premier signal de comparaison pour chaque marque de cadencement correspondante, et
(c) la détermination d'un taux d'erreurs sur les bits du signal d'essai numérique (20), en comparant le signal d'échantillonnage (60A) à un signal de réponse attendu du DUT ;
**caractérisé par**
(d) la dérivation du signal de cadencement (70) avec les marques de cadencement successives du signal d'essai numérique (20).

9. Procédé suivant la revendication 8, dans lequel l'étape (d) comprend une étape de dérivation du signal d'essai numérique (20) d'un signal d'horloge afin d'en dériver le signal de cadencement (70).
